# EUROPEAN PATENT APPLICATION

(11) **EP 3 637 135 A1**
(43) Date of publication of application: **15.04.2020**
(21) Application number: 18200171.9
(22) Date of filing: 12.10.2018
(51) Int. Cl.: G01S 7/497, G01R 31/02, G01R 31/28, H04N 17/04, H04N 5/3745

(54) **METHOD TO DETECT SHORTED INPUT PINS IN SOLID-STATE OPTICAL RECEIVERS BEFORE AND/OR DURING OPERATION**

(71) Applicant: IDT Inc., San Jose, CA 95138 (US)
(72) Inventor: TAVANO, Giuseppe, 80992 München (DE)
(74) Representative: Lippert Stachow Patentanwälte Rechtsanwälte Partnerschaft mbB

(57) **Abstract**

The invention relates to a solid-state optical receiver system 1, particularly for automotive applications, comprising at least two optical receiver circuits 2, each optical receiver circuit 2 comprising an optical receiver 3 for detecting an optical input signal, and a signal processing unit 4 for processing the signal of the optical receiver 3, which is characterized in that the solid-state optical receiver system 1 comprises a short-circuit detection unit 5 for detecting a short-circuit 6 between optical receiver circuits 2. The invention further relates to a method for detecting a short-circuit 6 between optical receiver circuits 2 of a solid-state optical receiver system 1, particularly for automotive applications.

## Description

The invention relates to solid-state optical receiver systems, particularly for automotive applications. The invention further relates to a method for detecting a short-circuit between optical receiver circuits of a solid-state optical receiver system, particularly for automotive applications.

Solid-state optical receiver systems are for example used in light detection and ranging (Lidar) systems, also called laser detection and ranging (Ladar) systems. Such systems measure the distance to a target by illuminating the target with pulsed laser light and measuring the reflected pulses with an optical sensor. Differences in laser return times and wavelength can then be used to make 3-D representations of the target. Lidar systems have become popular in automotive applications, for example in advanced safety systems. A lidar systems is for example used to scan the surroundings of a car to detect any obstacles on a collision course with the car and issue a warning to the driver and/or to initiate an emergency brake. Lidar systems are often used in autonomous cars for controlling and navigation purposes. In such automotive applications it is essential that the Lidar systems is highly available and precise with a minimum of detection errors.

The optical sensor of a Lidar systems commonly uses a solid-state optical receiver system for measuring the reflected pulses. Such a solid-state optical receiver system comprises at least two optical receiver circuits, but most likely a string of optical receiver circuits with tens of elements. Each optical receiver circuit comprises an optical receiver for detecting an optical input signal and a signal processing unit for processing the signal of the optical receiver.

Since the optical receiver system is important for the overall precision of the Lidar system it is an object of the present invention to provide a solid-state optical receiver system which is highly available and precise with a minimum of detection errors.

The object is solved by a solid-state optical receiver system, particularly for automotive applications, comprising at least two optical receiver circuits, each optical receiver circuit comprising an optical receiver for detecting an optical input signal, and a signal processing unit for processing the signal of the optical receiver, which is characterized in that the solid-state optical receiver system comprises a short-circuit detection unit for detecting a short-circuit between optical receiver circuits.

It has been found out that a common source of failure for such solid-state optical receiver systems result from a short-circuit between optical receiver circuits. Such short-circuits can already occur during manufacturing of the solid-state optical receiver system, especially because multiple optical receiver systems are arranged on the same die. On the other hand, short-circuits can occur during use of such solid-state optical receiver systems, especially in automotive applications, because of the environmental stresses during use. Due to the detection unit for detecting a short-circuit between optical receiver circuits errors or inaccuracies caused by the short-circuit between optical receiver circuits can be avoided, for example by replacing the solid-state optical receiver system.

According to a variant of the invention the optical receivers of the at least two optical receiver circuits are bundled in a first integrated circuit and the signal processing units of the at least two optical receiver circuits are bundled in a second integrated circuit. The first integrated circuit and second integrated circuit can be arranged on a single printed circuit board or on separate printed circuit boards, which are connect to each other for example by a cable. This variant is particularly advantageous for automotive applications because the integrated circuit containing the optical receivers can be arranged e.g. at the front of the car and the second integrated circuit containing the signal processing units can be arranged inside the car. Since the connection between both integrated circuits could be damaged, for example by a marten bite, the short-circuit detection unit according to the invention is particularly advantageous.

In an advantageous variant of the invention the signal processing unit comprises an amplifier for amplifying the signal of the optical receiver and/or an analog-to-digital converter for converting the signal of the optical receiver or the signal of the amplifier to a digital signal.

Advantageously the solid-state optical receiver system further comprises at least one microcontroller for storing and/or processing the digital signal of the analog-to-digital converter. Alternatively the signal of the analog-to-digital converter could be transmitted to a microcontroller of an external system, for example directly by the analog-to-digital converter.

According to a particularly preferred variant of the invention the optical receiver is a photodiode. A photodiode can be easily manufactured in a solid-state optical receiver system. Furthermore, a photodiode is cost efficient with respect to manufacturing costs and required chip size.

In a preferred variant of the invention the short-circuit detection unit comprises a signal generator for generating a test signal, wherein the test signal is applied to the connection between the optical receiver and the signal processing unit of a first optical receiver circuit. By applying the test signal to the connection between the optical receiver and the signal processing unit of a first optical receiver circuit a short-circuit to another optical receiver circuit can be detected by an output of the signal processing unit of the another optical receiver circuit. For example, the solid-state optical receiver system can comprise one signal generator, which can apply the test signal to every optical receiver circuit. In this variant the test signal is nevertheless only applied to one optical receiver circuit at a time. Alternatively, every optical receiver circuit can comprise a signal generator, wherein only one signal generator is active at a time.

In a variant of the invention each optical receiver circuit comprises a switch between the optical receiver and the signal processing unit, wherein the switch is actuated by the short-circuit detection unit. Advantageously the switch is arranged directly adjacent to the signal processing unit, so that no signal is transmitted to the signal processing unit if the switch is in the open state. In this way the signal processing unit of the first optical receiver circuit, to which the test signal is applied, can be disconnected from the other optical receiver circuits. Thus, the signal processing unit of the first optical receiver circuit has no influence on the short-circuit detection. Only a short-circuit to another optical receiver circuit can cause an output signal of any optical receiver circuit.

According to a preferred variant each optical receiver circuit comprises a clamping circuit, which provides a short-circuit to ground if actuated, wherein the clamping circuit is actuated by the short-circuit detection unit. After the test signal has been applied to the first optical receiver circuit and the output signal of the other optical receiver circuits has been checked at least the clamping circuit of the first optical receiver circuit is activated to ground connect the first optical receiver circuit to ground, in order to short-circuit the applied test signal to ground. Thus, the test signal can have no influence on the following short-circuit detection measurements and/or the active use of the solid-state optical receiver system. An activation of the clamping circuit of the first optical receiver circuit is enough because even if a short-circuit to another optical receiver circuit is present, this another optical receiver circuit is grounded via the short-circuit.

In a particularly preferred variant of the invention the short-circuit detection unit comprises a control unit, wherein the control unit is designed to implement a method for detecting a short-circuit between optical receiver circuits of a solid-state optical receiver system. The control unit can implement all necessary steps to execute the method for detecting a short-circuit between optical receiver circuits of a solid-state optical receiver system, like applying a test signal, monitoring the output signals of the other optical receiver circuits and/or indicating a possible short-circuit between optical receiver circuits. The control unit can further synchronize the subsequent testing of all optical receiver circuits of the solid-state optical receiver system before use and/or during use.

The above-mentioned object is further solver by a method for detecting a short-circuit between optical receiver circuits of a solid-state optical receiver system, particularly for automotive applications, comprising the steps of:
generating a test signal,
applying the test signal to a first optical receiver circuit, particularly between an optical receiver and a signal processing unit of the first optical receiver circuit,
monitoring the output signal of other optical receiver circuits of the solid-state optical receiver system, particularly of optical receiver circuits arranged next to the first optical receiver circuit, and
indicating a short-circuit between the first optical receiver circuit and another optical receiver circuit if the another optical receiver circuit generates an output signal.

The method according to the invention detects short-circuits between optical receiver circuits of a solid-state optical receiver system. Such short-circuits between optical receiver circuits have a negative impact on the accuracy and in the worst case on the availability of the solid-state optical receiver system. By applying a test signal to a first optical receiver circuit a short-circuit of this first optical receiver circuit with another optical receiver circuit can be detected by monitoring the output signals of the other optical receiver circuits.

In an advantageous variant of the invention the method further comprises the step of interrupting the connection between the optical receiver and the signal processing unit of the first optical receiver circuit before applying the test signal to the first optical receiver circuit, so that the applied test signal is not received by the signal processing unit of the first optical receiver circuit. By interrupting the connection between the optical receiver and the signal processing unit of the first optical receiver circuit the signal processing unit of the first optical receiver circuit has no influence on the method because it is disconnected from the other optical receiver circuits during the detection of a possible short-circuit.

According to a variant of the invention the method comprises the further step of connecting the first optical receiver circuit, preferably between the optical receiver and the signal processing unit, to ground, after the output signals of the other optical receiver circuits of the solid-state optical receiver system have been monitored. By connecting the first optical receiver circuit to ground, the applied test signal is short-circuited to ground, so that the applies test signal can have no influence following short-circuit detections and/or on the use of the solid-state optical receiver system.

Advantageously the steps of the method are repeated for all optical receiver circuits of the solid-state optical receiver system to detect any short-circuit between optical receiver circuits.

According to a variant of the invention the method is executed before installation and/or use of the solid-state optical receiver system. Thus, the optical receiver system is checked before use and it is guaranteed that the optical receiver system has no short-circuits between optical receiver circuits due to manufacturing faults. Alternatively or additionally the method is executed during use of the solid-state optical receiver system. Thus, the optical receiver system can detect any short-circuits between optical receiver circuits that occur during use of the solid-state optical receiver system, for example due to the use of the solid-state optical receiver system in automotive applications. If such a short-circuit between optical receiver circuits is detected a warning could be issued to the user of the system.

In a particularly preferred variant the method is executed periodically, preferably at times where no optical input signal is expected. By periodically executing the method according to the invention a malfunction of the optical receiver system or a degraded accuracy is detected as soon as possible and a corresponding warning could be issued to the user of the system. Preferably the method is executed at intervals where no optical input signal is expected, for example between the light pulses send by a Lidar-system.

According to a further variant of the invention the optical receivers of the optical receiver circuits are disabled during execution of the method according to the invention. In this way no signals are sent from the optical receivers to the signal processing units of the optical receiver circuits, which might have a negative impact on the method according to the invention.

In the following the invention will be further explained with respect to the embodiments shown in the figures. It shows:
Fig. 1 a block diagram of a first embodiment of a solid-state receiver system according to the invention,
Fig. 2 a block diagram of a second embodiment of a solid-state receiver system according to the invention, and
Fig. 3 a detailed block diagram of a short-circuit detection unit and signal processing unit.

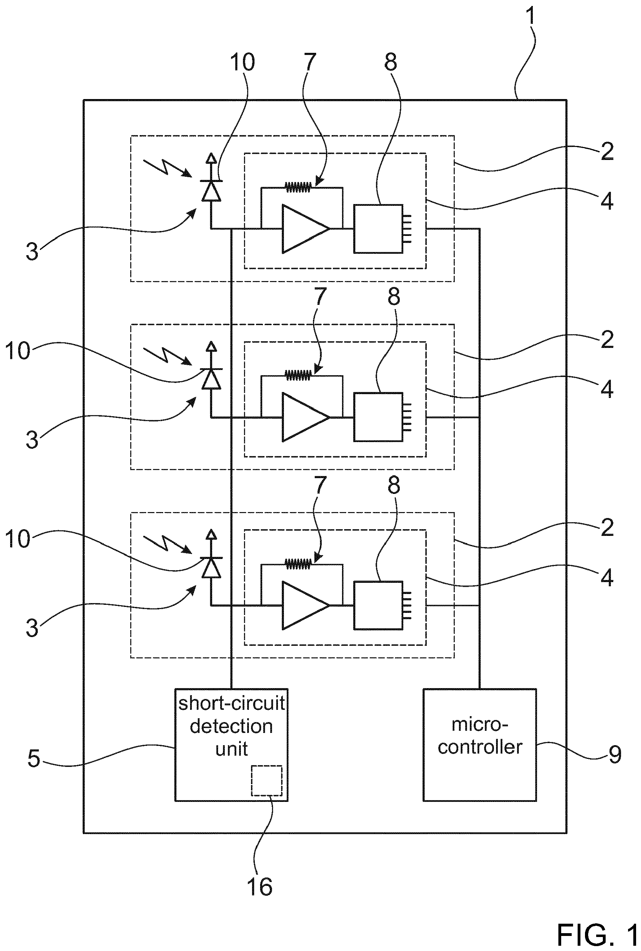

Fig. 1 shows a block diagram of a solid-state optical receiver system 1, particularly for automotive applications. The solid-state optical receiver system 1 shown in Fig. 1 comprises three optical receiver circuits 2. However, this number of optical receiver circuits 2 is only exemplary and in real life the solid-state optical receiver system 1 can comprise many more optical receiver circuits 2.

Each optical receiver circuits comprises an optical receiver 3 for detecting an optical input signal and a signal processing unit 4 for processing the signal of the optical receiver.

The solid-state optical receiver system of Fig. 1 further comprises a short-circuit detection unit 5 for detecting a short-circuit 6 between optical receiver circuits 2.

The signal processing units 4 of the optical receiver circuits 2 each comprise an amplifier 7 for amplifying the signal of the optical receiver 3 and an analog-to-digital converter 8 for converting the signal of the amplifier 7 to a digital signal.

The solid-state optical receiver system of Fig. 1 further comprises a microcontroller 9 for storing and/or processing the digital signals of the analog-to-digital converters 8 of the optical receiver circuits 2.

According to the embodiment of Fig. 1 the optical receiver 3 of the optical receiver circuits 2 are photodiodes 10.

The short-circuit detection unit 5 preferably comprises a control unit 16, which implements a method for detecting a short-circuit 6 between optical receiver circuits 2 of the solid-state optical receiver system 1, comprising the steps of:
generating a test signal 12,
applying the test signal 12 to a first optical receiver circuit 2, particularly between an optical receiver 3 and a signal processing unit 4 of the first optical receiver circuit 2,
monitoring the output signal of other optical receiver circuits 2 of the solid-state optical receiver system 1, particularly of optical receiver circuits 2 arranged next to the first optical receiver circuit 2, and
indicating a short-circuit 6 between the first optical receiver circuit 2 and another optical receiver circuit 2 if the another optical receiver circuit 2 generates an output signal.

These steps are repeated for all optical receiver circuits 2 of the solid-state optical receiver system 1.

The method is preferably executed before installation and/or use of the solid-state optical receiver system 1. Although the solid-state optical receiver system 1 has been preferably tested before installation and/or use the method is advantageously executed during use of the solid-state optical receiver system 1 to detect short-circuits 6 occurring during use of the solid-state optical receiver system 1. The method is executed periodically during use of the solid-state optical receiver system 1, preferably at times where no input signal is expected or the optical receivers 3 of the optical receiver circuits 2 are disabled during execution of the method.

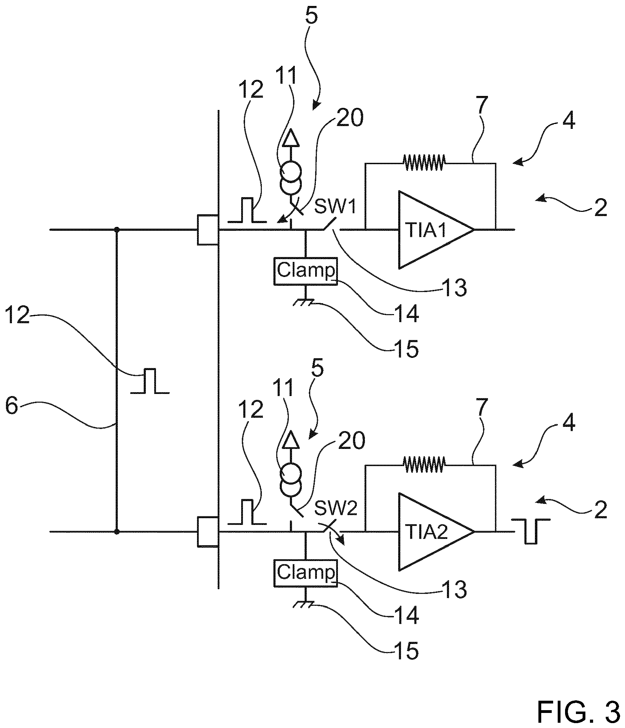

The method can further comprise the step of interrupting the connection between the optical receiver 3 and the signal processing unit 4 of the first optical receiver circuit 2 before applying the test signal 12 to the first optical receiver circuit 2, so that the applied test signal 12 is not received by the signal processing unit 4 of the first optical receiver circuit 2. The method can further comprise the step of connecting the first optical receiver circuit 2, preferably between the optical receiver 3 and the signal processing unit 4, to ground. These steps will be explained later in detail with the embodiment shown in Fig. 3.

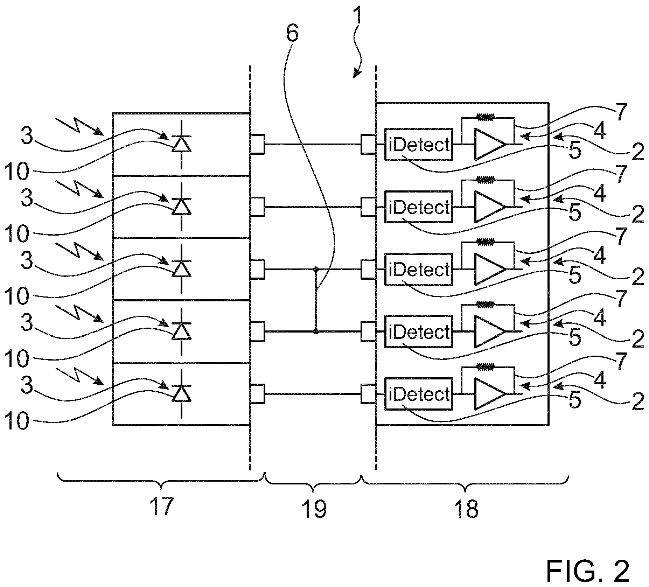

Fig. 2 shows a block diagram of a second embodiment of a solid-state receiver system 1 according to the invention. The embodiment according to Fig. 2 comprises five optical receiver circuits 2. Each optical receiver circuit 2 comprises an optical receiver 3, particularly a photodiode 10, for detecting an optical input signal, and a signal processing unit 4 for processing the signal of the optical receiver 3.

The optical receivers 3 of the five optical receiver circuits 2 are bundled in a first integrated circuit 17 and the signal processing units 4 of the five optical receiver circuits 2 are bundled in a second integrated circuit 18. The first integrated circuit 17 and second integrated circuit 18 are connect to each other for example by a cable 19.

The solid-state optical receiver system 1 of Fig. 2 further comprises a short-circuit detection unit 5 for detecting a short-circuit 6 between optical receiver circuits 2. Parts of the short-circuit detection unit 5 are arranged between the optical receiver 3 and the signal processing unit 4 of each optical receiver circuit 2. These parts are preferably located close to the signal processing units 4 of the optical receiver circuits 2 and are advantageously also arranged on the second integrated circuit 18. The parts of the short-circuit detection unit 5 are arranged between the optical receiver 3 and the signal processing unit 4 of each optical receiver circuit 2 will be explained in more detail with respect to the embodiment shown in Fig. 3.

The short-circuit detection unit 5 further comprises a control unit 16 (not shown in Fig. 2) for controlling the parts of the short-circuit detection unit 5 are arranged between the optical receiver 3 and the signal processing unit 4 of each optical receiver circuit 2.

The signal processing unit 4 comprises an amplifier 7 for amplifying the signal of the corresponding optical receiver 3. As explained with respect to the embodiment shown in Fig. 1 the signal processing unit 4 can further comprise an analog-to-digital converter 8 for converting the signal of the optical receiver 3 or the signal of the amplifier 7 to a digital signal. The digital signal can be for example stored and/or processed by a microcontroller (not shown in Fig. 2) of the solid-state optical receiver system 1.

In Fig. 2 a short-circuit 6 is shown between the third and fourth optical receiver circuit 2, particularly in the cable 19 connecting the first integrated circuit 17 and the second integrated circuit 18, which will be detected by the short-circuit detection unit 5 of the solid-state optical receiver system 1.

Fig. 3 shows a detailed block diagram of a short-circuit detection unit 5 and signal processing unit 4 of a solid-state optical receiver system 1. The solid-state optical receiver system 1 of Fig. 3 comprises two optical receiver circuits 2. The optical receivers 3 of the optical receiver circuits 2 are not shown in Fig. 3.

Fig. 3 particularly shows the details of the parts of the short-circuit detection unit 5 arranged next to the signal processing unit 4 of the optical receiver circuits 2. These parts comprise a signal generator 11 for generating a test signal 12. The test signal 12 can be applied to the connection between the optical receiver 3 and the signal processing unit 4 of a first optical receiver circuit 2. Therefore, the generator can comprise a generator switch 20.

The optical receiver circuit 2 further comprises a switch 13 between the optical receiver 3 and the signal processing unit 4, wherein the switch is actuated by the short-circuit detection unit 5. The switch is arranged directly adjacent to the signal processing unit 4, so that the test signal 12 is not transmitted to the signal processing unit 4 if the switch 13 is in the open state.

The optical receiver circuit 2 further comprises a clamping circuit 14, which provides a short-circuit to ground 15 if actuated, wherein the clamping circuit 14 is actuated by the short-circuit detection unit 5.

For detecting a short-circuit 6 between the upper optical receiver circuit 2 and the lower optical receiver circuit 2 of the solid-state optical receiver system 1 of Fig. 3 the generator switch 20 of the generator 11 of the upper optical receiver circuit 2 is closed and the switch 13 of the upper optical receiver circuit 2 is opened, so that the signal processing unit 4 of the upper optical receiver circuit 4 is disconnected from the generator 11. At the same time the signal generator 11 of the lower optical receiver circuit 2 is disconnected from the lower optical receiver circuit 2 by the opened generator switch 20 and the signal processing unit 4 of the lower optical receiver circuit 2 is connected to the lower optical receiver circuit 2 by the closed switch 13. The states of the switches 13 and generator switches 20 are indicated by an arrow for a closed state and without an arrow for the opened state.

The test signal 12 of the upper signal generator 11 can travel via the short-circuit 6 to the signal processing unit 5 of the lower optical receiver 2, which will produce a corresponding output indicating the short-circuit 6.

To avoid any disturbances created by the test signal 12 during the use of the solid-state optical receiver system 1 at least the upper optical receiver circuit 2 is connected to ground 15 by the clamping circuit 14, thereby short-circuiting the test signal 12 to ground 15. After grounding the test signal 12 the solid-state optical receiver system 1 is ready for use or testing of the next optical receiver circuit 2. In fact, the clamping circuit 14 is only required if there is no short-circuit 6 between the first optical receiver circuit 2 and any other optical receiver circuit 2 because in that case there is no current path to ground 15 for the test signal 12. Thus, the test signal 12 could cause an overload if it is not connected to ground 15 by the clamping circuit 14.

### Method to detect shorted input pins in solid-state optical receivers before and/or during operation

### List of references

- 1: solid-state optical receiver system
- 2: optical receiver circuit
- 3: optical receiver
- 4: signal processing unit
- 5: short-circuit detection unit
- 6: short-circuit
- 7: amplifier
- 8: analog-to-digital converter
- 9: microcontroller
- 10: photodiode
- 11: signal generator
- 12: test signal
- 13: switch
- 14: clamping circuit
- 15: ground
- 16: control unit
- 17: first integrated circuit
- 18: second integrated circuit
- 19: cable
- 20: generator switch

## Claims

1. Solid-state optical receiver system (1), particularly for automotive applications, comprising at least two optical receiver circuits (2), each optical receiver circuit (2) comprising:
an optical receiver (3) for detecting an optical input signal, and
a signal processing unit (4) for processing the signal of the optical receiver (3),
**characterized in that**
the solid-state optical receiver system (1) comprises a short-circuit detection unit (5) for detecting a short-circuit (6) between optical receiver circuits (2).

2. Solid-state optical receiver system (1) according to claim 1,
**characterized in that**
the signal processing unit (4) comprises an amplifier (7) for amplifying the signal of the optical receiver (3) .

3. Solid-state optical receiver system (1) according to claim 1 or claim 2,
**characterized in that**
the signal processing unit (4) comprises an analog-to-digital converter (8) for converting the signal of the optical receiver (3) or the signal of the amplifier (7) to a digital signal.

4. Solid-state optical receiver system (1) according to claim 3,
further comprising at least one microcontroller (9) for storing and/or processing the digital signal of the analog-to-digital converter (8).

5. Solid-state optical receiver system (1) according to any of claims 1 to 4,
**characterized in that**
the optical receiver (3) is a photodiode (10).

6. Solid-state optical receiver system (1) according to any of claims 1 to 5,
**characterized in that**
the short-circuit detection unit (5) comprises a signal generator (11) for generating a test signal (12), wherein the test signal (12) is applied to the connection between the optical receiver (3) and the signal processing unit (4) of a first optical receiver circuit (2).

7. Solid-state optical receiver system (1) according to any of claims 1 to 6
**characterized in that**
each optical receiver circuit (2) comprises a switch (13) between the optical receiver (3) and the signal processing unit (4), wherein the switch (13) is actuated by the short-circuit detection unit (5).

8. Solid-state optical receiver system (1) according to claim 7
**characterized in that**
the switch (13) is arranged directly adjacent to the signal processing unit (4), so that no signal is transmitted to the signal processing unit (4) if the switch (13) is in the open state.

9. Solid-state optical receiver system (1) according to any of claims 1 to 8,
**characterized in that**
each optical receiver circuit (2) comprises a clamping circuit (14), which provides a short-circuit to ground (15) if actuated, wherein the clamping circuit (14) is actuated by the short-circuit detection unit (5).

10. Solid-state optical receiver system (1) according to any of claims 1 to 9,
**characterized in that**
the short-circuit detection unit (5) comprises a control unit (16), wherein the control unit (16) is designed to implement the method according to any of claims 11 to 18.

11. Method for detecting a short-circuit (6) between optical receiver circuits (2) of a solid-state optical receiver system (1), particularly for automotive applications, comprising the steps of:
generating a test signa (12)1,
applying the test signal (12) to a first optical receiver circuit (2), particularly between an optical receiver (3) and a signal processing unit (4) of the first optical receiver circuit (2),
monitoring the output signal of other optical receiver circuits (2) of the solid-state optical receiver system (1), particularly of optical receiver circuits (2) arranged next to the first optical receiver circuit (2), and
indicating a short-circuit (6) between the first optical receiver circuit (2) and another optical receiver circuit (2) if the another optical receiver circuit (2) generates an output signal.

12. Method for detecting a short-circuit (6) between optical receiver circuits (2) of a solid-state optical receiver system (1) according to claim 11,
further comprising the step of interrupting the connection between the optical receiver (3) and the signal processing unit (4) of the first optical receiver circuit (2) before applying the test signal (12) to the first optical receiver circuit (2), so that the applied test signal (12) is not received by the signal processing unit (4) of the first optical receiver circuit (2).

13. Method for detecting a short-circuit (6) between optical receiver circuits (2) of a solid-state optical receiver system (1) according to claim 11 or claim 12, further comprising the step of connecting the first optical receiver circuit (2), preferably between the optical receiver (3) and the signal processing unit (4), to ground (15).

14. Method for detecting a short-circuit (6) between optical receiver circuits (2) of a solid-state optical receiver system (1) according to any of claims 11 to 13,
wherein the steps are repeated for all optical receiver circuits (2) of the solid-state optical receiver system (1) .

15. Method for detecting a short-circuit (6) between optical receiver circuits (2) of a solid-state optical receiver system (1) according to any of claims 11 to 14,
wherein the method is executed before installation and/or use of the solid-state optical receiver system (1) .

16. Method for detecting a short-circuit (6) between optical receiver circuits (2) of a solid-state optical receiver system (1) according to any of claims 11 to 15,
wherein the method is executed during use of the solid-state optical receiver system (1).

17. Method for detecting a short-circuit (6) between optical receiver circuits (2) of a solid-state optical receiver system (1) according to claim 16,
wherein the method is executed periodically, preferably at times where no optical input signal is expected.

18. Method for detecting a short-circuit (6) between optical receiver circuits (2) of a solid-state optical receiver system (1) according to claim 17,
wherein the optical receivers (3) of the optical receiver circuits (2) are disabled during execution of the method.
